# EUROPÄISCHE PATENTSCHRIFT

(11) **EP 1 610 603 B1**
(45) Veröffentlichungstag und Bekanntmachung des Hinweises auf die Patenterteilung: **21.02.2007**
(21) Anmeldenummer: 05011781.1
(22) Anmeldetag: 01.06.2005
(51) Int. Cl.: H05K 5/02, H05K 5/04

(54) **Gehäuse zur Aufnahme elektrischer und/oder elektronischer Bauteile**
Casing for receiving electrical and/or electronic components
Boîtier pour composants électriques et/ou électroniques

(30) Priorität: 24.06.2004 DE 102004030666
(43) Veröffentlichungstag der Anmeldung: 28.12.2005
(73) Patentinhaber: i f m electronic gmbh, D-45127 Essen (DE)
(72) Erfinder: Weber, Michael, 88074 Meckenbeuren (DE); Heinrich, Wolfgang, 88069 Tettnang (DE); Hornstein, Andreas, 88131 Lindau (DE); Mehnert, Wolfgang, 88131 Lindau (DE); Sauter, Franz, 88069 Tettnang (DE); Siegler, Ralf, 86281 Schlier (DE)
(74) Vertreter: Gesthuysen, von Rohr & Eggert

(56) Entgegenhaltungen:
- EP-A- 1 186 821
- DE-A1- 19 718 392
- DE-C1- 10 119 910
- US-A- 3 096 654

## Beschreibung

Die Erfindung betrifft ein Gehäuse zur Aufnahme elektrischer und/oder elektronischer Bauteile, mit einer Gehäuseöffnung und mit einem in der Gehäuseöffnung drehbar angeordneten Anschlußstutzen, wobei der Anschlußstutzen ein zylindrisches Aufnahmeteil aufweist, in dem eine Ringnut ausgebildet ist, und durch ein Befestigungsmittel im Gehäuse gehalten ist. Daneben betrifft die Erfindung noch einen Anschlußstutzen zur drehbaren Anordnung in einer Gehäuseöffnung eines Gehäuse eines elektrischen bzw. elektronischen Gerätes, insbesondere eines optischen, induktiven oder kapazitiven Näherungsschalters.

Bei dem eingangs beschriebenen Gehäuse kann es sich insbesondere um das Gehäuse eines Sensors, beispielsweise eines induktiven, kapazitiven oder optischen Näherungsschalters handeln. Innerhalb des Gehäuses sind dann das eigentliche Sensorelement sowie weitere elektrische und elektronische Bauteile, beispielsweise eine Auswerteschaltung, angeordnet. Zum elektrischen Anschluß bzw. zur elektrischen Verbindung mit weiteren Geräten, beispielsweise einer zentralen Steuerung, weist das Gehäuse einen Anschlußstutzen auf, der als Kabel- oder Steckerausgang dient.

Ein derartiges Gehäuse ist beispielsweise aus der DE 197 18 392 C2 bekannt. Bei dem bekannten Gehäuse weist der Anschlußstutzen einen Schnappfortsatz mit einer geschlitzten Arretierungswulst auf, mit deren Hilfe der Anschlußstutzen in der Gehäuseöffnung eingerastet werden kann. Zusätzlich dieser Schnappverbindung sind an dem Gehäuse Hinterschneidungen und an dem Anschlußstutzen komplementär zu den Hinterschneidungen ausgebildete und mit den Hinterschneidungen in Eingriff bringbare Stabilisierungsansätze vorgesehen. Durch die Ausbildung der Hinterschneidungen und der Stabilisierungsansätze, die den Anschlußstutzen und das Gehäuse zusätzlich miteinander verbinden, wird erreicht, daß auf den Anschlußstutzen wirkende Kräfte nicht mehr ausschließlich von der Schnappverbindung aufgenommen werden müssen.

Um ein unbeabsichtigtes Lösen des Anschlußstutzens aus der Gehäuseöffnung zu verhindern, ist darüber hinaus vorgesehen, daß von der Gehäuseinnenseite her ein zylindrisches Sperrelement in den Schnappfortsatz eingebracht wird, wodurch gewährleistet ist, daß sich der Arretierungswulst des Schnappfortsatzes nicht radial nach innen bewegen kann, wodurch es zu einem Lösen der Schnappverbindung kommen würde. Durch die zuvor beschriebenen Maßnahmen läßt sich der Anschlußstutzen zwar sicher mit dem Gehäuse verankern, hierfür ist jedoch eine sehr spezielle Ausbildung sowohl des Gehäuses als auch des Anschlußstutzens erforderlich.

Ein weiteres Gehäuse der eingangs beschriebenen Art ist aus der DE 199 52 643 C1 bekannt. Auch bei diesem Gehäuse ist ein Anschlußstutzen wahlweise in verschiedenen Positionen in der Gehäuseöffnung befestigbar. Hierbei ist die Gehäuseöffnung als Nabenbohrung ausgebildet, wobei der Anschlußstutzen mittels einer am Gehäusedeckel und/oder am Gehäuseboden integrierten Verriegelungslasche fixierbar ist. Die Verriegelungslaschen weisen Rasthaken auf, mittels derer der Anschlußstutzen in unterschiedlichen Drehstellungen fixierbar ist. Auch die in der DE 199 52 643 C1 beschriebene Lösung erfordert somit eine spezielle Ausgestaltung des Gehäuses, insbesondere des Gehäusedeckels und/oder des Gehäusebodens.

Schließlich ist aus der DE 101 19 910 C1 ein Gehäuse mit einem drehbar in einer Gehäuseöffnung angeordneten Anschlußstutzen bekannt, bei dem zur Fixierung des Anschlußstutzens in einer ersten oder zweiten Drehposition ein im Gehäuseinnenraum fixiertes Einlegeteil mit einem Einsatz vorgesehen ist, wobei der Einsatz von dem zylindrischen Aufnahmeteil des Anschlußstutzens umschlossen wird und wobei an dem Aufnahmeteil und dem Einsatz zusammenwirkende Rastmittel vorgesehen sind.

Allen bekannten Gehäusen ist gemeinsam, daß die Verrastung und Fixierung des Anschlußstutzens in der Gehäuseöffnung bei zumindest teilweise geöffneten Gehäuse erfolgen muß, d. h. das Gehäuse erst nach der Montage des Anschlußstutzens geschlossen werden kann. Handelt es sich bei dem Gehäuse ― wie eingangs ausgeführt ― um das Gehäuse eines Näherungsschalters, so ist es aufgrund der Einsatzbedingungen des Näherungsschalters häufig erforderlich, daß der Näherungsschalter zum Schutz der in dem Gehäuse angeordneten elektrischen und elektronischen Bauteile vergossen wird. Der Verguß eines Näherungsschalters ist selbstverständlich jedoch erst dann möglich, wenn in dem Gehäuse alle elektrischen und elektronischen Bauteile angeordnet und das Gehäuse - mit Ausnahme einer Öffnung zum Einfüllen des Gießharzes - verschlossen ist. Bei den bekannten Gehäusen ist daher die Montage der elektrischen und elektronischen Bauteile und insbesondere das Vergießen des Gehäuses erst nach der Montage des Anschlußstutzens möglich.

Aufgrund der Vielzahl der unterschiedlichen Ausführungsvarianten von in der Praxis eingesetzten Näherungsschaltern besteht das Bedürfnis, die Näherungsschalter möglichst modulartig aufzubauen, um die Anzahl der im Lager gehaltenen Näherungsschalter zu verringern. Beispielsweise können sich ansonsten baugleiche Näherungsschalter nur dadurch unterscheiden, daß sie einen Steckerausgang, einen Kabelausgang oder einen Anschlußraum für die Adern eines elektrischen Kabels aufweisen. Hierzu sind dann unterschiedlich ausgestaltete Anschlußstutzen erforderlich. Bei einem modulartigen Aufbau des eigentlichen Gehäuses und des Anschlußstutzens könnten beide Bauteile unabhängig voneinander gefertigt und gelagert werden und erst bei Bedarf entsprechend zusammenmontiert werden.

Der vorliegenden Erfindung liegt daher die Aufgabe zugrunde, ein Gehäuse der eingangs beschriebenen Art so auszugestalten, daß der Anschlußstutzen mit möglichst einfachen Mitteln sicher am Gehäuse befestigbar ist. Darüber hinaus soll die Montage des Anschlußstutzens an dem Gehäuse nach Möglichkeit eine modulare Fertigung von Gehäuse und Anschlußstutzen ermöglichen.

Die zuvor genannten Aufgabe ist bei dem eingangs beschriebenen Gehäuse zur Aufnahme elektrischer und/oder elektronischer Bauteile dadurch gelöst, daß zur axialen Sicherung des Anschlußstutzens in der Gehäuseöffnung ein offener, mit einer Einführschräge versehener und in der Ringnut des Anschlußstutzens geführter Sprengring aus Kunststoff vorgesehen ist, der im montierten Zustand des Anschlußstutzens zumindest teilweise in einer Nut in der Gehäuseöffnung eingerastet ist. Dadurch, daß als Befestigungsmittel ein Kunststoff-Sprengring mit einer Einführschräge verwendet wird, kann der Anschlußstutzen mit aufgestecktem Sprengring aufgrund der radialen Federwirkung des Kunststoff-Sprengrings ― bei ansonsten geschlossenem Gehäuse ― von außen durch die Gehäuseöffnung eingesteckt werden. Da der Sprengring anschließend in der in der Gehäuseöffnung ausgebildeten Nut einrastet, ist die Anordnung eines zusätzlichen Sperrelements von der Gehäuseinnenseite her nicht erforderlich, so daß das Gehäuse ― mit Ausnahme der Gehäuseöffnung zur Aufnahme des Anschlußstutzens ― bei der Montage des Anschlußstutzens bereits vollständig geschlossen sein kann.

Durch die erfindungsgemäße Befestigung des Anschlußstutzens in der Gehäuseöffnung besteht somit die Möglichkeit, einen Sensor bereits fertig zu montieren, und bei Bedarf auch bereits zu vergießen, so daß auch eine elektrische Funktionsprüfung des Sensors durchgeführt werden kann, bevor das Gehäuse mit dem Anschlußstutzen verbunden wird. Wird der Sensor vergossen, so kann die Gehäuseöffnung als Einfüllöffnung für das Gießharz verwendet werden. Durch die erfindungsgemäße Ausgestaltung des Gehäuses besteht somit die Möglichkeit, ein elektronisches Gerät, beispielsweise einen Näherungsschalter, modulartig auszugestalten, d. h. das Gehäuse mit den elektrischen und elektronischen Bauteilen fertig montiert, vergossen und elektrisch geprüft zu lagern, und erst bei Bedarf das Gehäuse mit einem entsprechenden Anschlußstutzen, der beispielsweise als Kabelanschluß oder als Steckeranschluß ausgebildet ist, zu versehen.

Gemäß einer bevorzugten Ausgestaltung der Erfindung ist das Profil des Sprengrings so gestaltet, daß der Sprengring im entspannten Zustand an seiner dem Gehäuse zugewandten Seite einen kleineren und an seiner dem Gehäuse abgewandten Seite einen größeren Durchmesser besitzt als die zur Aufnahme des Anschlußstutzens bestimmte Gehäuseöffnung. Durch eine derartige Dimensionierung des Sprengringes, in Verbindung mit der Einführschräge, die vorzugsweise einen Winkel von ca. 25° - 45° zur Mittelachse des Sprengringes aufweist, ist einerseits ein relativ einfaches Einstecken des Aufnahmeteils des Anschlußstutzens in die Gehäuseöffnung möglich, andererseits jedoch auch eine sichere Fixierung des Anschlußstutzens in dem Gehäuse gewährleistet.

Zur Erhöhung der Dichtigkeit der Verbindung zwischen Gehäuse und Anschlußstutzen ist in dem Aufnahmeteil und/oder in der Gehäuseöffnung zumindest noch eine weitere Ringnut zur Aufnahme eines Dichtungsringes ausgebildet. Vorzugsweise ist sowohl in dem Aufnahmeteil als auch in der Gehäuseöffnung jeweils eine Ringnut vorgesehen, so daß eine doppelte Dichtung realisiert werden kann und somit eine 1-Fehler Sicherheit gewährleistet ist.

Zur Begrenzung der maximalen Drehbewegung des Anschlußstutzens in der Gehäuseöffnung ist in der dem Gehäuse zugewandten Stirnseite des Anschlußstutzens eine nur teilweise umlaufende Nut und an der dem Anschlußstutzen zugewandten Seite des Gehäuses eine korrespondierende Nase ausgebildet. Wird der Anschlußstutzen mit seinem Aufnahmeteil in die Gehäuseöffnung eingesteckt, so greift die am Gehäuse angeformte Nase in die am Anschlußstutzen ausgebildete Nut ein. Dadurch, daß die Nut nur teilweise, vorzugsweise um ca. 270° umlaufend ist, wird durch das Zusammenwirken der Nase mit der Nut die Bewegung des Anschlußstutzens auf Drehungen von maximal 270° begrenzt.

Eingangs ist ausgeführt worden, daß der Sprengring aus einem Kunststoff besteht, wodurch der Sprengring ― im Unterschied zu einem Sprengring aus Metall ― eine ausreichende Elastizität aufweist, so daß das Aufnahmeteil des Anschlußstutzens mit eingelegtem Sprengring in die Gehäuseöffnung eingedrückt werden kann, ohne das ein Werkzeug zum Zusammendrücken des Sprengringes erforderlich ist. Vorzugsweise besteht nicht nur der Sprengring sondern darüber hinaus auch der Anschlußstutzen und das Gehäuse aus einem Kunststoff. Hierdurch ist zunächst eine kostengünstige Herstellung sowohl des Anschlußstutzens als auch des Gehäuses möglich. Darüber hinaus kann durch eine entsprechende Abstimmung der Materialeigenschaften des für das Gehäuse, den Anschlußstutzen und den Sprengring verwendeten Kunststoffes eine Beschädigung von Gehäuse, Anschlußstutzen oder Sprengring beim Einrasten des Anschlußstutzens in die Gehäuseöffnung vermieden werden. Vorzugsweise bestehen dazu zumindest der Anschlußstutzen und der Sprengring aus dem gleichen Kunststoff, insbesondere aus PEEK (Polyetheretherketon) oder PPS (Polyphenylensulfid). Darüber hinaus können jedoch auch andere, an die jeweiligen Anwendungen angepaßte Kunststoffe verwendet werden.

Wie eingangs ausgeführt, betrifft die Erfindung neben einem Gehäuse mit einem Anschlußstutzen auch den Anschlußstutzen zur drehbaren Anordnung in einer Gehäuseöffnung eines Gehäuses eines elektrischen bzw. elektronischen selber. Der Anschlußstutzen, der ein zylindrisches Aufnahmeteil mit einer Ringnut und einen Grundkörper aufweist, ist gemäß Patentanspruch 10 erfindungsgemäß dadurch gekennzeichnet, daß zur axialen Sicherung des Anschlußstutzens in der Gehäuseöffnung ein offener, mit einer Einführschräge versehener Sprengring aus Kunststoff in der Ringnut angeordnet ist, wobei der Sprengring im montierten Zustand des Anschlußstutzens teilweise in einer Nut in der Gehäuseöffnung einrastet.

Bezüglich der Vorteile, die mit einem derartigen Anschlußstutzen erreicht werden können und bezüglich der vorteilhaften Ausgestaltung eines derartigen Anschlußstutzens wird auf die vorherigen Ausführungen im Zusammenhang mit dem erfindungsgemäßen Gehäuse sowie auf die nachgeordneten Patentansprüche 11 bis 13 verwiesen.

Im einzelnen gibt es nun eine Vielzahl von Möglichkeiten, das erfindungsgemäße Gehäuse bzw. den erfindungsgemäßen Anschlußstutzen auszugestalten und weiterzubilden. Dazu wird verwiesen auf die den Patentansprüchen 1 und 10 nachgeordneten Patentansprüche sowie auf die Beschreibung eines bevorzugten Ausführungsbeispiels in Verbindung mit der Zeichnung. In der Zeichnungen zeigen
- Fig. 1: das erfindungsgemäße Gehäuse mit eingerastetem Anschlußstutzen, im Schnitt,
- Fig. 2: das Gehäuse, den Anschlußstutzen und den Sprengring, im noch nicht montierten Zustand,
- Fig. 3: den Anschlußstutzen im Schnitt und
- Fig. 4: den Anschlußstutzen mit separatem Sprengring und mit in der Ringnut eingelegtem Sprengring.

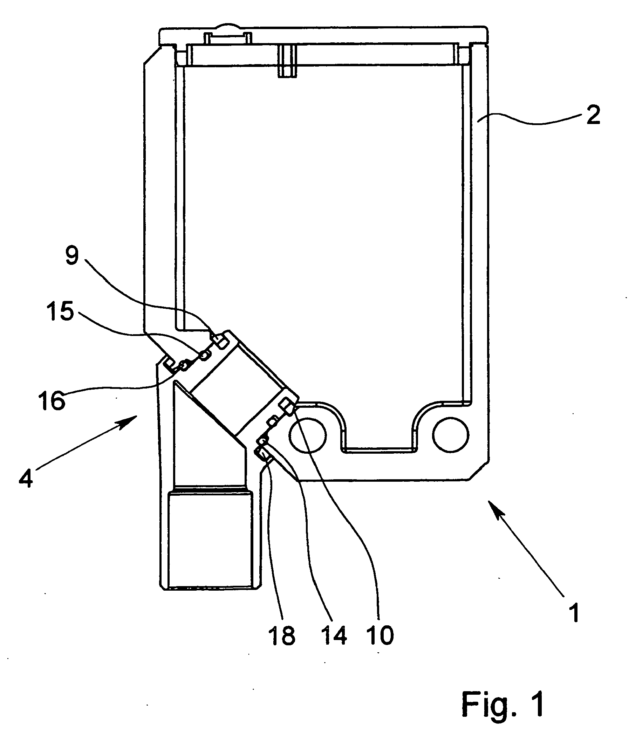

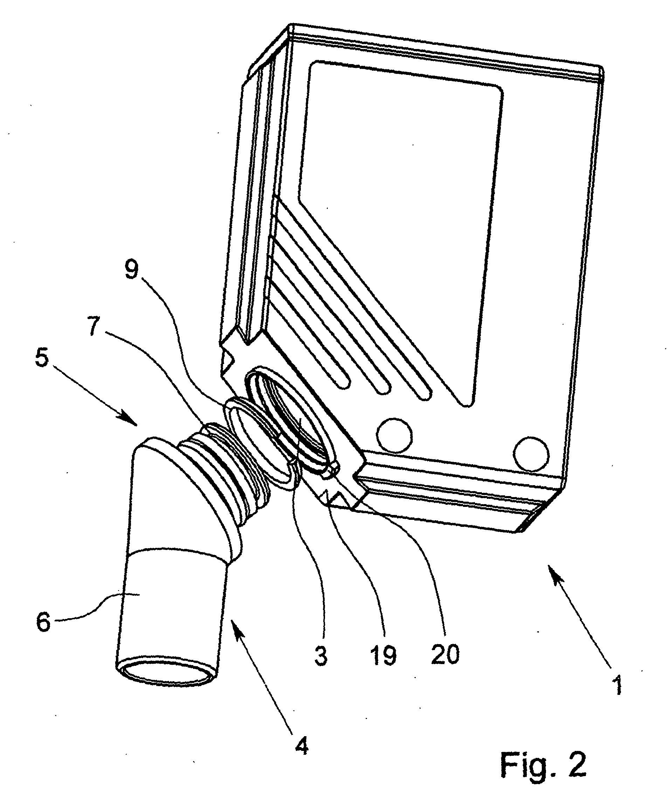

Die Fig. 1 und 2 zeigen einen Näherungsschalter 1 mit einem Gehäuse 2 zur Aufnahme der elektrischen und elektronischen Bauteile. In dem Gehäuse 2 ist eine Gehäuseöffnung 3 vorgesehen, die zur Aufnahme eines Anschlußstutzens 4 dient. Der Anschlußstutzen 4 weist ein im montierten Zustand innerhalb der Gehäuseöffnung 3 eingerastetes Aufnahmeteil 5 und einen zylindrischen Grundkörper 6 auf, wobei die Längsachse des Aufnahmeteils 5 und die Längsachse des Grundkörpers 6 ― im dargestellten Ausführungsbeispiels ― einen Winkel von 135° zueinander aufweisen. Selbstverständlich können die Längsachse des Aufnahmeteils 5 und die Längsachse des Grundkörpers 6 auch zusammenfallen oder einem anderen Winkel zueinander aufweisen.

Zur Befestigung des Anschlußstutzens 4 an dem Gehäuse 2 ist in einer in dem Aufnahmeteil 5 ausgebildeten Ringnut 7 ein mit einer Einführschräge 8 versehener Sprengring 9 angeordnet. Der Sprengring 9 besteht dabei ebenso wie der Anschlußstutzen 4 aus Kunststoff, wobei zumindest für den Anschlußstutzen 4 und den Sprengring 9 jeweils ein Kunststoff mit ähnlichen Materialeigenschaften, insbesondere bezüglich der Härte und des Elastizitätsmoduls, verwendet wird. Im montierten Zustand des Anschlußstutzens 4 ist der Sprengring 9 teilweise in einer Nut 10 in der Gehäuseöffnung 3 eingerastet, wodurch der Anschlußstutzen 4 axial fixiert aber dennoch drehbar an dem Gehäuse 2 befestigt ist.

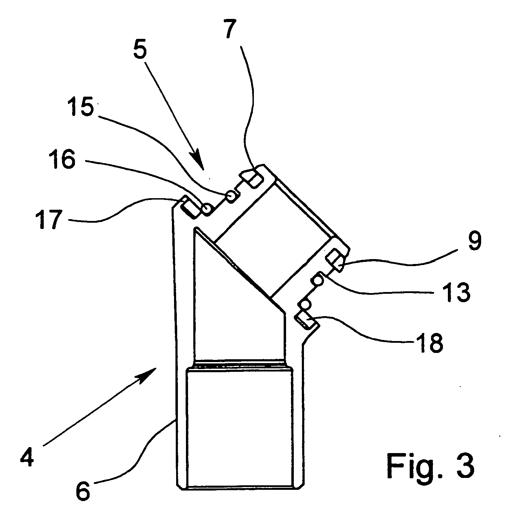

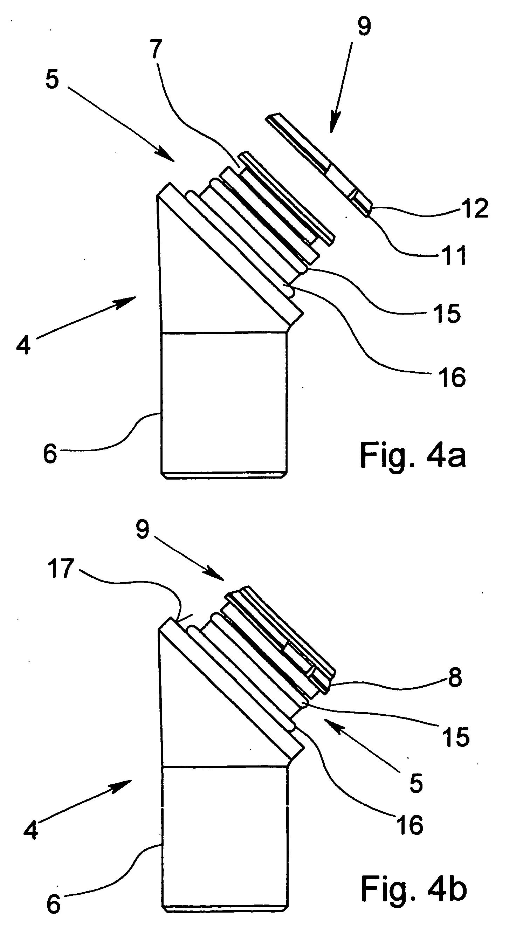

Der Anschlußstutzen 4 ist dabei so dimensioniert, daß er im entspannten Zustand an seiner dem Gehäuse 2 zugewandten Seite einen kleineren und an seiner dem Gehäuse 2 abgewandten Seite einen größeren Durchmesser als die zur Aufnahme des Anschlußstutzens 4 bestimmte Gehäuseöffnung 3 aufweist. Insbesondere aus den den Anschlußstützen 4 zeigenden Fig. 3 und 4 ist dabei ersichtlich, daß das Profil des Sprengrings 9 aus einem rechteckigen Bereich 11 und einem daran anschließenden dreieckigen Bereich 12 zusammengesetzt ist. Die durch den dreieckigen Bereich 12 gebildete Einführschräge 8 weist dabei einen Winkel von ca. 30° zur Mittelachse des Sprengrings 9 auf. Bei einem maximalen Außendurchmesser des Sprengrings 9 von ca. 10 bis 15 mm und eine Höhe des Sprengrings 9 von ca. 1,0 bis 1,5 mm ist der Außendurchmesser des Sprengringes 9 an seiner dem Gehäuse 2 zugewandten Seite im entspannten Zustand ca. 2 mm kleiner als der maximale Außendurchmesser. Dieser Unterschied zwischen dem maximalen und dem minimalen Außendurchmesser des Sprengringes 9 zusammen mit der Einfährschräge 8 ist ausreichend, um zum einen ein Eindrücken des Aufnahmeteils 5 mit in der Ringnut 7 angeordnetem Sprengring 9 in die Gehäuseöffnung 3 mit relativ geringem Kraftaufwand zu ermöglichen, gewährleistet gleichzeitig aber eine ausreichende axiale Fixierung des Anschlußstutzens 4 an dem Gehäuse 2.

Insbesondere aus der Fig. 1 ist erkennbar, daß sowohl in der Gehäuseöffnung 3 als auch am Aufnahmeteil 5 des Anschlußstutzens 4 jeweils noch eine weitere Ringnut 13, 14 zur Aufnahme eines Dichtungsringes 15, 16 ausgebildet ist. Bei dem dargestellten Gehäuse 2 ist somit eine doppelte Dichtung zwischen der Gehäuseöffnung 3 und dem Anschlußstutzen 4 vorgesehen, wodurch das Gehäuse 2 den Anforderungen an eine 1-Fehler Sicherheit genügt.

Aus einer Zusammenschau der Fig. 1 und 2 ist darüber hinaus ersichtlich, daß in der dem Gehäuse 2 zugewandten Stirnseite 17 des Anschlußstutzens 4 eine nur teilweise umlaufende Nut 18 und an der dem Anschlußstutzen 4 zugewandten Seite 19 des Gehäuses 2 eine korrespondierende Nase 20 ausgebildet ist. Hierdurch erfolgt eine Begrenzung der maximal möglichen Drehbewegung des Anschlußstutzens 4 in der Gehäuseöffnung 3. Selbstverständlich ist es dabei auch möglich, eine entsprechende Nut im Gehäuse 2 und eine korrespondierende Nase an der Stirnseite 17 des Anschlußstutzens 4 vorzusehen.

Je nach Anwendungsfall kann der Anschlußstutzen 4 als Kabel- oder Steckerausgang ausgebildet sein. Ist der Anschlußstutzen 4 als Steckerausgang ausgebildet, so sind in dem Grundkörper 6 des Anschlußstutzens 4 entsprechende Kontaktstifte angeordnet, die mit korrespondierenden Kontaktbuchsen eines Anschlußsteckers verbunden werden können. Anstelle von Kontaktstiften können in dem Grundkörper 6 natürlich auch Kontaktbuchsen angeordnet sein, so daß der Anschlußstutzen 4 einen Buchsenausgang darstellt. Ebenso kann jedoch auch der Grundkörper 6 des Anschlußstutzens 4 als Anschlußraum für die Adern eines elektrischen Kabels ausgebildet sein. In dem Grundkörper 6 sind dann entsprechende Kontaktelemente angeordnet, die der elektrische Kontaktierung der Adern eines anzuschließendes Kabels dienen.

## Patentansprüche

1. Gehäuse zur Aufnahme elektrischer und/oder elektronischer Bauteile, mit einer Gehäuseöffnung (3) und mit einem in der Gehäuseöffnung (3) drehbar angeordneten Anschlußstutzen (4), wobei der Anschlußstutzen (4) ein zylindrisches Aufnahmeteil (5) aufweist, in dem eine Ringnut (7) ausgebildet ist, und durch ein Befestigungsmittel im Gehäuse (1) gehalten ist,
**dadurch gekennzeichnet,**
**daß** zur axialen Sicherung des Anschlußstutzens (4) in der Gehäuseöffnung (3) ein offener, mit einer Einführschräge (8) versehener und in der Ringnut (6) geführter Sprengring (9) aus Kunststoff vorgesehen ist, der im montierten Zustand des Anschlußstutzens (4) zumindest teilweise in einer Nut (10) in der Gehäuseöffnung (3) eingerastet ist.

2. Gehäuse nach Anspruch 1, **dadurch gekennzeichnet, daß** das Profil des Sprengrings (9) so gestaltet ist, daß er im entspannten Zustand an seiner dem Gehäuse (2) zugewandten Seite einen kleineren und an seiner dem Gehäuse (2) abgewandten Seite einen größeren Außendurchmesser besitzt als die zur Aufnahme des Anschlußstutzens (4) bestimmte Gehäuseöffnung (3).

3. Gehäuse nach Anspruch 1 oder 2, **dadurch gekennzeichnet, daß** das Profil des Sprengrings (9) aus einem rechteckigen Bereich (11) und einem dreieckigen Bereich (12) zusammengesetzt ist.

4. Gehäuse nach einem der Ansprüche 1 bis 3, **dadurch gekennzeichnet, daß** die Einführschräge (8) einen Winkel α von 25° bis 45°, vorzugsweise von ca. 30°, zur Mittelachse aufweist.

5. Gehäuse nach einem der Ansprüche 1 bis 4, **dadurch gekennzeichnet, daß** in dem Aufnahmeteil (5) und/oder in der Gehäuseöffnung (3) mindestens noch eine weitere Ringnut (13, 14) zur Aufnahme eines Dichtungsringes (15, 16) ausgebildet ist.

6. Gehäuse nach einem der Ansprüche 1 bis 5, **dadurch gekennzeichnet, daß** in der dem Gehäuse (2) zugewandeten Stirnseite (17) des Anschlußstutzens (4) eine nur teilweise, vorzugsweise um ca. 270° umlaufende Nut (18) und an der dem Anschlußstutzen (4) zugewandten Seite (19) des Gehäuses (2) eine korrespondierende Nase (20) ausgebildet ist.

7. Gehäuse nach einem der Ansprüche 1 bis 6, **dadurch gekennzeichnet, daß** der Anschlußstutzen (4) und vorzugsweise auch das Gehäuse (2) aus Kunststoff besteht.

8. Gehäuse nach Anspruch 7, **dadurch gekennzeichnet, daß** der Anschlußstutzen (4) und der Sprengring (9) jeweils aus einem Kunststoff mit ähnlichen Materialeigenschaften, insbesondere bezüglich Härte und Elastizitätsmoduls, bestehen.

9. Gehäuse nach Anspruch 8, **dadurch gekennzeichnet, daß** der Anschlußstutzen (4), der Sprengring (9) und vorzugsweise auch das Gehäuse (2) aus dem selben Kunststoff, insbesondere aus PA (Polyamid), PEEK (Polyetheretherketon), PPS (Polyphenylensulfid), PBT bzw. PBTP (Polybutylenterephthalat), PPE (Polyphenylenether), PPO (Polyphenylenoxid) oder PTFE (Polytetrafluorethylen), bestehen.

10. Anschlußstutzen zur drehbaren Anordnung in einer Gehäuseöffnung (3) eines Gehäuse (2) eines elektrischen bzw. elektronischen Gerätes, insbesondere eines optischen, induktiven oder kapazitiven Näherungsschalters (1), mit einem zylindrischen Aufnahmeteil (5), in dem eine Ringnut (7) ausgebildet ist, und mit einem Grundkörper (6),
**dadurch gekennzeichnet,**
**daß** zur axialen Sicherung des Anschlußstutzens (4) in der Gehäuseöffnung (3) ein offener, mit einer Einführschräge (8) versehener Sprengring (9) aus Kunststoff in der Ringnut (7) angeordnet ist, wobei der Sprengring (9) im montierten Zustand des Anschlußstutzens (4) teilweise in einer Nut (9) in der Gehäuseöffnung (3) einrastet.

11. Anschlußstutzen nach Anspruch 10, **dadurch gekennzeichnet, daß** die Einführschräge (8) einen Winkel α von 25° bis 45°, vorzugsweise von ca. 30°, zur Mittelachse aufweist, und daß das Profil des Sprengringes (9) aus einem rechteckigen Bereich (11) und einem dreieckigen Bereich (12) zusammengesetzt ist.

12. Anschlußstutzen nach Anspruch 10 oder 11, **dadurch gekennzeichnet, daß** in dem Aufnahmeteil (5) mindestens eine weitere Ringnut (13) zur Aufnahme eines Dichtungsringes (15) und in der dem Gehäuse (2) zugewandeten Stirnseite (17) des Anschlußstutzens (4) eine nur teilweise, vorzugsweise um ca. 270° umlaufende Nut (18) ausgebildet ist.

13. Anschlußstutzen nach einem der Ansprüche 10 bis 12, **dadurch gekennzeichnet, daß** der Anschlußstutzen (4) und der Federring (9) aus dem gleichen Kunststoff bestehen.

## Claims

1. Housing for holding at least one of electrical and electronic components, comprising a housing opening (3) and an entry fitting (4) which is rotationally located in the housing opening (3), the entry fitting (4) having a cylindrical holding part (5) in which an annular groove (7) is formed, and being secured in the housing (2) by a fastener,
**characterised in that**,
an open plastic snap ring (9) is provided for axialy securing the entry fitting (4) in the housing opening (3), the snap ring (9) has a feed bevel (8) and is guided in the annular groove (7), and, in the installed state of the entry fitting (4), is locked at least partially in a groove (10) in the housing opening (3).

2. Housing according to Claim 1, wherein the snap ring (9) has a profile which, in a relieved state has a smaller diameter than the housing opening (3) which is intended for accommodating the entry fitting (4) on the side facing the housing (2) and has a larger diameter than the housing opening (3) on the side facing away from the housing (2).

3. Housing according to Claim 1 or 2, wherein the profile of the snap ring (9) is composed of a rectangular area (11) and a triangular area (12).

4. Housing according to one of Claims 1 to 3, wherein the feed bevel (8) has an angle α from 25° to 45°, preferably roughly 30°, relative to a central axis.

5. Housing according to one of Claims 1 to 4, wherein, in at least one of a holding part (5) and the housing opening (3), at least a second annular groove (13, 14) is provided for holding a seal (15, 16).

6. Housing according to one of Claims 1 to 5, wherein in the front side (17) of the entry fitting (4), facing the housing (2) a partially circular , preferably running roughly 270°, groove (18) is provided and on the side (19) of the housing (2) facing the entry fitting (4), a corresponding projection (20) is provided

7. Housing according to one of Claims 1 to 6, wherein the entry fitting (4) and preferably also the housing (2) is made of plastic.

8. Housing according to Claim 7, wherein the entry fitting (4) and the snap ring (9) are made of a plastic with similar material properties, in particular regarding hardness and coefficient of elasticity.

9. Housing according to Claim 8, wherein the entry fitting (4) and the snap ring (9) and preferably also the housing (2) are made of the same plastic, said plastic is selected preferably from the group consisting of of PA (polyamide), PEEK (polyether ether ketone), PPS (polyphenyl sulfide), PBT or PBTP (polybutylene terephthalate), PPE (polyphenylene ether), PPO (polyphenylene oxide), or PTFE (polytetra fluorethylene).

10. Entry fitting for rotational arrangement in a housing opening (3) of a housing (2) of an electrical or electronic device, in particular an optical, inductive or capacative proximity switch, comprising a cylindrical holding part (5) having an annular groove (7), and a base body (6),
**characterised in that**,
for axially securing the entry fitting (4) in the housing opening (3), an open plastic snap ring (9) with a feed bevel (8) is anrranged in the annular groove (7), wherein the snap ring (9), in the installed state of the entry fitting (4), is locked partially in a groove (10) in the housing opening (3).

11. Entry fitting according to Claim 10, wherein the feed bevel (8) has an angle α from 25° to 45°, preferably roughly 30°, relative to a central axis, and wherein the profile of the snap ring (9) is composed of a rectangular area and a triangular area.

12. Entry fitting according to Claim 10 or 11, wherein in the holding part (5) at least a second annular groove (13) for holding a seal (15), and in the front side (17) of the entry fitting (4), facing the housing (2) a partially circular, preferably running roughly 270°, groove (18) is provided.

13. Entry fitting according to one of Claims 10 to 12, wherein the entry fitting (4) and the snap ring (9) are made of the same plastic.

## Revendications

1. Boîtier pour le logement de composants électriques et/ou électroniques, avec une ouverture de boîtier (3) et une tubulure de raccordement (4) qui est disposée de façon rotative dans l'ouverture de boîtier (3), la tubulure de raccordement (4) comportant un élément d'admission (5) cylindrique, dans lequel est formée une rainure annulaire (7), et étant maintenue dans le boîtier (2) à l'aide d'un moyen de fixation,
**caractérisé en ce que**
une bague de butée (9) ouverte en plastique est prévue pour la fixation axiale de la tubulure de raccordement (4) dans l'ouverture de boîtier (3), la bague étant pourvue d'un biais d'introduction (8) et insérée dans la rainure annulaire (7), et au moins partiellement encliquetée dans une rainure (10) formée dans l'ouverture de boîtier (3) lorsque la tubulure de raccordement (4) est à l'état monté.

2. Boîtier selon la revendication 1, **caractérisé en ce que** le profil de la bague de butée (9) est conçu de façon à ce qu'à l'état détendu, son diamètre externe soit inférieur du côté tourné vers le boîtier (2) et supérieur du côté opposé au boîtier (2) par rapport à l'ouverture de boîtier (3) définie pour le logement de la tubulure de raccordement (4).

3. Boîtier selon la revendication 1 ou 2, **caractérisé en ce que** le profil de la bague de butée (9) se compose d'une zone rectangulaire (11) et d'une zone triangulaire (12).

4. Boîtier selon les revendications 1 à 3, **caractérisé en ce que** le biais d'introduction (8) forme un angle α de 25°-45°, préférentiellement d'environ 30°, avec l'axe médian.

5. Boîtier selon l'une des revendications 1 à 4, **caractérisé en ce que** au moins une rainure annulaire supplémentaire (13, 14) est formée dans l'élément d'admission (5) et/ou dans l'ouverture de boîtier (3) pour le logement d'anneaux d'étanchéité (15, 16).

6. Boîtier selon l'une des revendications 1 à 5, **caractérisé en ce que** le côté frontal (17) de la tubulure de raccordement (4), qui est tourné vers le boîtier (2), comporte une rainure (18) seulement partiellement annulaire, préférentiellement de 270°, et **en ce que** le côté (19) du boîtier (2) qui est tourné vers la tubulure de raccordement (4) comporte une saillie (20) correspondante.

7. Boîtier selon l'une des revendications 1 à 6, **caractérisé en ce que** la tubulure de raccordement (4) et préférentiellement également le boîtier (2) sont conçus en plastique.

8. Boîtier selon la revendication 7, **caractérisé en ce que** la tubulure de raccordement (4) et la bague de butée (9) sont chacune composées de matières plastiques possédant les mêmes caractéristiques, notamment en ce qui concerne la dureté et l'élasticité.

9. Boîtier selon la revendication 8, **caractérisé en ce que** la tubulure de raccordement (4), la bague de butée (9) et de préférence également le boîtier (2) sont composés du même plastique, notamment de PA (Polyamide), PEEK (Polyétheréthercétone), PPS (Polyphénylène sulfure), PBT ou PBTP (Polybutylène téréphtalate), PPE (Polyphénylène ether), PPO (Polyphénylène oxyde) ou PTFE (Polytétrafluoréthylène).

10. Tubulure de raccordement pour agencement rotatif dans une ouverture de boîtier (3) du boîtier (2) d'un appareil électrique ou électronique, notamment d'un détecteur de proximité (1) optique, inductif ou capacitaire, avec un élément d'admission (5) cylindrique, dans lequel est formée une rainure annulaire (7), et avec un corps de base (6),
**caractérisée en ce que**
une bague de butée (9) ouverte en plastique est prévue pour la fixation axiale de la tubulure de raccordement (4) dans l'ouverture de boîtier (3), la bague étant pourvue d'un biais d'introduction (8) et insérée dans la rainure annulaire (7), et la bague de butée (9) étant partiellement encliquetée dans une rainure (10) formée dans l'ouverture de boîtier (3) lorsque la tubulure de raccordement (4) est à l'état monté.

11. Tubulure de raccordement selon la revendication 10, **caractérisée en ce que** le biais d'introduction (8) forme un angle α de 25°-45°, préférentiellement d'environ 30°, avec l'axe médian, et **en ce que** le profil de la bague de butée (9) se compose d'une zone rectangulaire (11) et une zone triangulaire (12).

12. Tubulure de raccordement selon la revendication 10 ou 11, **caractérisée en ce que** l'élément d'admission (5) comporte au moins une rainure annulaire (13) supplémentaire pour le logement d'un anneau d'étanchéité (15), et **en ce que** le côté frontal (17) de la tubulure de raccordement (4), qui est tourné vers le boîtier (2) comporte une rainure (18) seulement partiellement annulaire, de préférence d'environ 270°.

13. Tubulure de raccordement selon l'une des revendications 10 à 12, **caractérisée en ce que** la tubulure de raccordement (4) et la bague élastique (9) sont constituées du même plastique.
